# FASCICULE DE BREVET EUROPEEN

(11) **EP 3 777 102 B1**
(45) Date de publication et mention de la délivrance du brevet: **09.02.2022**
(21) Numéro de dépôt: 19713792.0
(22) Date de dépôt: 26.03.2019
(51) Int. Cl.: H04L 29/08, H04W 4/70, G01D 4/00, H04B 3/54

(54) **TRANSMISSION DE DONNÉES DEPUIS UNE ENTITÉ DE GESTION VERS UN COMPTEUR ÉLECTRIQUE INTELLIGENT**
DATENÜBERTRAGUNG VON EINER VERWALTUNGSEINHEIT ZU EINEM INTELLIGENTEN STROMZÄHLER
DATA TRANSMISSION FROM A MANAGEMENT ENTITY TO A SMART ELECTRICITY METER

(30) Priorité: 27.03.2018 FR 1852648
(43) Date de publication de la demande: 17.02.2021
(73) Titulaire: Sagemcom Energy & Telecom SAS, 92500 Rueil-Malmaison (FR)
(72) Inventeur: TEBOULLE, Henri, 92500 RUEIL MALMAISON (FR); LECAPPON, Jean-Paul, 92500 RUEIL MALMAISON (FR)
(74) Mandataire: Cabinet Le Guen Maillet
(86) Numéro de dépôt international: PCT/EP2019/057633
(87) Numéro de publication internationale: WO 2019/185655

(56) Documents cités:
- EP-A1- 3 122 061
- US-A1- 2016 118 793
- TREVOR ARMSTRONG ET AL: "Efficient and transparent dynamic content updates for mobile clients", MOBISYS 2006. THE 4TH. INTERNATIONAL CONFERENCE ON MOBILE SYSTEMS, APPLICATIONS AND SERVICES. UPPSALA, SWEDEN, JUNE 19 - 22, 2006; [INTERNATIONAL CONFERENCE ON MOBILE SYSTEMS, APPLICATIONS AND SERVICES], NEW YORK, NY : ACM, US, 19 juin 2006 (2006-06-19), pages 56-68, XP058107993, DOI: 10.1145/1134680.1134687 ISBN: 978-1-59593-195-5

## Description

La présente invention concerne une transmission de données vers des compteurs électriques intelligents depuis une entité de gestion d'un système de communication auquel lesdits compteurs électriques appartiennent.

Les réseaux de communication par courants porteurs en ligne (« PowerLine Communications » en anglais) pour des systèmes de type AMM (« Automated Meter Management » en anglais) ont fait leur apparition ces dernières années. On peut par exemple citer les spécifications PRIME (« PoweRline Intelligent Metering Evolution » en anglais) et le standard G3-PLC spécifié dans la recommandation ITU-T G.9903. Dans de tels réseaux de communication par courants porteurs en ligne, des communications sont établies entre des compteurs électriques, dits intelligents (« smart electrical meters » en anglais), et un dispositif concentrateur de données (« data concentrator » en anglais), parfois appelé *nœud de base* (« base node » en anglais), ou *coordinateur* (« coordinator » en anglais), pour permettre notamment une relève automatisée à distance de mesures de consommation électrique effectuées par lesdits compteurs électriques intelligents. Une pluralité de tels dispositifs concentrateurs de données est typiquement géographiquement déployée de manière à répartir la charge de gestion à distance d'une multitude de compteurs électriques intelligents, chaque dispositif concentrateur de données étant ensuite connecté à une même entité de gestion du système de type AMM qui est gérée par l'opérateur du réseau d'alimentation électrique auquel lesdits compteurs électriques intelligents sont connectés.

De telles communications par courants porteurs en ligne doivent faire face à des interférences liées à des phénomènes de diaphonie, et/ou à un manque de fiabilité de certains liens de communication dans le réseau de communication par courants porteurs en ligne (*e.g.* limite de portée due à la longueur des câbles), et/ou à des bruits de différentes natures (bruits blancs, bruits colorés, bruits impulsionnels principalement), et/ou à des désadaptations d'impédance. Pour rappel, la diaphonie est un phénomène qui permet à des signaux, typiquement par couplage capacitif, de se propager sans passer par des paires de cuivre proprement dites, mais par des liens parasites non visibles. Ce phénomène est instable, car pouvant varier en fonction de la température ou de l'activité sur le réseau de communication par courants porteurs en ligne. A noter qu'il peut également y avoir de la diaphonie au sein d'un même appareil via des liaisons cuivre sur circuits imprimés et/ou via certains composants qui constituent ledit appareil. Ces phénomènes peuvent entraîner des pertes de paquets ou messages, notamment de paquets ou messages de signalisation, et entraîner des déconnexions de dispositifs nœuds du réseau de communication. Une telle instabilité des réseaux de communication par courants porteurs en ligne rend problématique la transmission de données vers les compteurs électriques intelligents depuis l'entité de gestion du système de type AMM, notamment en termes de latence puisque, par exemple, les reconfigurations du réseau de communication suite à des déconnexions de compteurs électriques intelligents, dont certains servent de relais entre un dispositif concentrateur de données et d'autres compteurs électriques intelligents, sont longues et fastidieuses.

Le document EP 3 122 061 Al décrit un système comportant des compteurs électriques intelligents connectés à un dispositif concentrateur via un premier réseau par courant porteurs en ligne et connectés à une passerelle de collecte via un second réseau de type LPWAN.

Le document « efficient and transparent dynamic content updates for mobile clients », Trevor Armstrong et al., MOBISYS 2006 décrit un serveur proxy interrogeant des serveurs web et regroupant des mises à jour en un seul lot à envoyer à un client et un autre proxy situé sur le client pouvant extraire lesdites mises à jour.

Il est souhaitable de pallier ces inconvénients de l'état de la technique, et notamment d'améliorer les capacités de transmission de données vers les compteurs électriques intelligents depuis l'entité de gestion du système de type AMM, notamment dans le cadre de mise à jour logicielle des compteurs électriques intelligents et/ou de mise à jour de profils utilisateurs associés à des utilisateurs de ces compteurs électriques intelligents.

L'invention concerne un procédé pour transmettre des données depuis une entité de gestion dans un système de communication comportant en outre au moins un dispositif concentrateur de données auquel sont rattachés des compteurs électriques intelligents via un premier réseau de communication par courants porteurs en ligne, chaque dispositif concentrateur de données étant connecté à l'entité de gestion via un second réseau de communication. Le procédé étant tel que, pour transmettre des données depuis l'entité de gestion vers un dit compteur électrique intelligent, ledit compteur électrique intelligent reçoit, en provenance de l'entité de gestion, via le premier réseau de communication par courants porteurs en ligne, un message indiquant qu'un transfert de données est en attente auprès de l'entité de gestion. De plus, ledit compteur électrique intelligent comportant une interface de communication sans-fil adaptée pour communiquer via un troisième réseau de communication local sans-fil avec une passerelle résidentielle connectée à l'entité de gestion via un quatrième réseau de communication, ledit compteur électrique intelligent obtient lesdites données auprès de l'entité de gestion via le troisième réseau de communication local sans-fil. Ainsi, grâce au troisième réseau de communication local sans-fil et à la passerelle résidentielle, le transfert des données depuis l'entité de gestion jusqu'audit compteur électrique intelligent est plus performant, en évitant de recourir au premier réseau de communication par courants porteurs en ligne pour le transfert desdites données.

Selon un mode de réalisation particulier, sur réception du message indiquant que le transfert de données est en attente auprès de l'entité de gestion, ledit compteur électrique intelligent effectue les étapes suivantes : déterminer si ledit compteur électrique intelligent dispose d'une connexion, via ledit troisième réseau de communication local sans-fil, avec ladite passerelle résidentielle lui permettant de communiquer avec l'entité de gestion par son biais ; obtenir lesdites données auprès de l'entité de gestion via le troisième réseau de communication local sans-fil lorsque ledit compteur électrique intelligent dispose d'une connexion, via ledit troisième réseau de communication local sans-fil, avec ladite passerelle résidentielle ; et obtenir lesdites données auprès de l'entité de gestion via le premier réseau de communication par courants porteurs en ligne lorsque ledit compteur électrique intelligent ne dispose pas d'une connexion, via ledit troisième réseau de communication local sans-fil, avec ladite passerelle résidentielle.

Selon un mode de réalisation particulier, ledit compteur électrique intelligent vérifie en outre si la quantité de données à transférer depuis l'entité de gestion est ou pas supérieure à un premier seuil prédéfini au-delà duquel la transmission de cette quantité de données par le réseau de communication par courants porteurs en ligne a une probabilité supérieure à un second seuil prédéfini de subir une reconfiguration du réseau de communication par courants porteurs en ligne. Alors, ledit compteur électrique intelligent obtient lesdites données auprès de l'entité de gestion via le troisième réseau de communication local sans-fil lorsque ledit compteur électrique intelligent dispose d'une connexion, via ledit troisième réseau de communication local sans-fil, avec ladite passerelle résidentielle et en outre que la quantité de données à transférer est supérieure audit premier seuil prédéfini.

Selon un mode de réalisation, ledit compteur électrique intelligent vérifie en outre si la quantité de données à transférer depuis l'entité de gestion est ou pas inférieure à une valeur, dite valeur limite, obtenue à partir d'une courbe prédéfinie reliant des quantités de données à télécharger à des valeurs représentatives de probabilités de réussite d'un téléchargement effectué via le réseau de communication par courants porteurs en ligne et d'une probabilité de réussite fournie par l'entité de gestion représentative d'une probabilité que le réseau de communication par courants porteurs en ligne ne subisse pas une reconfiguration au moment où le compteur électrique intelligent débutera ledit téléchargement, ledit compteur électrique intelligent obtenant lesdites données auprès de l'entité de gestion via le réseau de communication par courant porteur en ligne lorsque la quantité de données à transférer est inférieure à la valeur limite.

Selon un mode de réalisation particulier, ledit compteur électrique intelligent exporte, via son interface de communication sans-fil, une page web de saisie pour permettre de saisir un nom de réseau et un mot de passe, et ledit compteur électrique intelligent se connecte à ladite passerelle résidentielle grâce au nom de réseau et au mot de passe saisis via ladite page web de saisie.

Selon un mode de réalisation particulier, ledit compteur électrique intelligent exporte la page web de saisie uniquement lorsque ledit compteur électrique intelligent ne dispose pas de nom de réseau et de mot de passe permettant d'utiliser son interface de communication sans-fil pour communiquer avec l'entité de gestion.

Selon un mode de réalisation particulier, après avoir obtenu lesdites données auprès de l'entité de gestion via le troisième réseau de communication local sans-fil, ledit compteur électrique intelligent effectue avec l'entité de gestion des échanges de confirmation de transfert réussi, lesdits échanges s'effectuant via le premier réseau de communication par courants porteurs en ligne.

Selon un mode de réalisation particulier, l'interface de communication sans-fil est de type Wi-Fi.

L'invention concerne également un compteur électrique intelligent configuré pour recevoir des données depuis une entité de gestion dans un système de communication comportant en outre au moins un dispositif concentrateur de données auquel est rattaché au moins ledit compteur électrique intelligent via un premier réseau de communication par courants porteurs en ligne, chaque dispositif concentrateur de données étant connecté à l'entité de gestion via un second réseau de communication. Pour transmettre des données depuis l'entité de gestion vers ledit compteur électrique intelligent, ledit compteur électrique intelligent comporte des moyens pour recevoir, en provenance de l'entité de gestion, via le premier réseau de communication par courants porteurs en ligne, un message indiquant qu'un transfert de données est en attente auprès de l'entité de gestion. De plus, ledit compteur électrique intelligent comporte une interface de communication sans-fil adaptée pour communiquer via un troisième réseau de communication local sans-fil avec une passerelle résidentielle connectée à l'entité de gestion via un quatrième réseau de communication, et des moyens pour obtenir lesdites données auprès de l'entité de gestion via le troisième réseau de communication local sans-fil.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la Fig. 1A illustre schématiquement un système de communication dans le cadre d'une gestion automatisée à distance de compteurs électriques intelligents, dans un mode de réalisation de l'invention ;
- la Fig. 1B illustre schématiquement une variante d'agencement d'une partie du système de communication de la Fig. 1A ;
- la Fig. 2 illustre schématiquement un exemple d'architecture matérielle de contrôle d'un compteur électrique intelligent du système de communication de la Fig. 1A ;
- la Fig. 3 illustre schématiquement un algorithme, exécuté par au moins un compteur électrique intelligent du système de la Fig. 1A, pour recevoir des données depuis une entité de gestion du système de la Fig. 1A ;
- la Fig. 4 illustre schématiquement un échange de messages dans le cadre d'un transfert de données dans le système de communication de la Fig. 1A, dans un mode de réalisation de la présente invention ; et
- la Fig. 5 illustre schématiquement un algorithme, exécuté par au moins un compteur électrique intelligent du système de la Fig. 1A, pour configurer une interface de communication dudit compteur électrique intelligent.

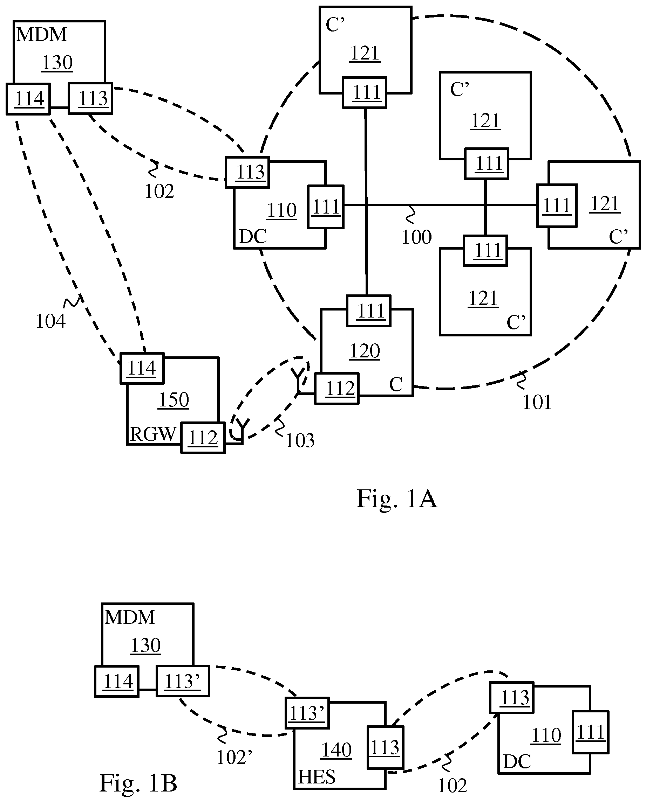

La **Fig. 1A** illustre schématiquement un système de communication dans le cadre d'une gestion automatisée à distance de compteurs électriques intelligents, dans un mode de réalisation de l'invention.

Le système de communication de la Fig. 1A, de type AMM, comporte une entité de gestion MDM (« Meter Data Management » en anglais) 130 dudit système et une pluralité de compteurs électriques intelligents C 120, C' 121.

L'entité de gestion MDM 130 est notamment en charge de collecter des informations transmises par les compteurs électriques intelligents C 120, C' 121, telles que des informations de relevés de consommation électrique d'installations électriques que lesdits compteurs électriques intelligents C 120, C' 121 sont en charge de surveiller, et pour transmettre des données, telles que des mises à jour logicielles et/ou des profils utilisateurs, auxdits compteurs électriques intelligents C 120, C' 121.

Pour permettre d'échanger des données entre les compteurs électriques intelligents C 120, C' 121 et l'entité de gestion MDM 130, des communications par courants porteurs en ligne sont établies entre chacun desdits compteurs électriques intelligents C 120, C' 121 et un dispositif concentrateur de données DC 110. Le système de communication comporte typiquement une pluralité de dispositifs concentrateurs de données DC 110, un seul étant représenté sur la Fig. 1A. A chaque dispositif concentrateur de données DC 110 est connectée, de manière logique, une pluralité de compteurs électriques intelligents C 120, C' 121, chaque dispositif concentrateur de données DC 110 servant ainsi de relais entre lesdits compteurs électriques intelligents C 120, C' 121 qui lui sont connectés et l'entité de gestion MDM 130. Un réseau de communication par courants porteurs en ligne 101 est ainsi formé entre chaque dispositif concentrateur de données DC 110 et la pluralité de compteurs électriques intelligents C 120, C' 121 qui lui est connectée, en s'appuyant sur un réseau d'alimentation électrique 100 servant à alimenter en électricité les installations électriques que lesdits compteurs électriques intelligents C 120, C' 121 sont en charge de surveiller.

Chaque compteur électrique intelligent C 120, C' 121 comporte ainsi une interface 111 de communication par courants porteurs en ligne permettant de communiquer via le réseau de communication par courants porteurs en ligne 101. De même, chaque dispositif concentrateur de données DC 110 comporte une telle interface 111 de communication par courants porteurs en ligne permettant de communiquer via le réseau de communication par courants porteurs en ligne 101. Selon un exemple de réalisation, le réseau de communication par courants porteurs en ligne 101 est conforme aux spécifications PRIME. Selon un autre exemple de réalisation, le réseau de communication par courants porteurs en ligne 101 est conforme au standard G3-PLC.

Il faut comprendre que la topologie du réseau de communication par courants porteurs en ligne 101 n'est pas figée. A cause notamment des phénomènes de diaphonie et autres interférences, des compteurs électriques intelligents C 120, C' 121 peuvent se trouver déconnectés du réseau de communication par courants porteurs en ligne 101 et cherchent alors à se réenregistrer au sein du réseau de communication par courants porteurs en ligne 101. La topologie du réseau de communication par courants porteurs en ligne 101 à ce moment-là est alors probablement différente de la topologie du réseau de communication par courants porteurs en ligne 101 avant déconnexion desdits compteurs électriques intelligents 120.

Pour permettre de relayer les informations échangées entre les compteurs électriques intelligents C 120, C' 121 à destination de l'entité de gestion MDM 130, chaque dispositif concentrateur de données DC 110 comporte en outre une interface 113 de communication avec un réseau de communication 102, auquel est aussi connectée l'entité de gestion MDM 130. Etant donné que les dispositifs concentrateurs de données DC 110 peuvent être typiquement installés au sein de postes de transformation du réseau d'alimentation électrique 100, le réseau de communication 102 est préférentiellement un réseau de télécommunication sans-fil. Selon un exemple de réalisation, le réseau de communication 102 est conforme au standard UMTS (« Universal Mobile Telecommunications System » en anglais). Selon un autre exemple de réalisation, le réseau de communication 102 est conforme au standard LTE (« Long Term Evolution » en anglais).

L'entité de gestion MDM 130 comporte aussi une interface 113 de communication avec le réseau de communication 102 lui permettant de communiquer avec une pluralité de dispositifs concentrateurs de données DC 110. Les communications entre l'entité de gestion MDM 130 et chaque dispositif concentrateur de données DC 110 peuvent s'effectuer via un ou plusieurs serveurs intermédiaires, comme illustré sur la Fig. 1B.

Sur la **Fig. 1B****,** l'entité de gestion MDM 130 est connectée à chaque dispositif concentrateur de données DC 110 via un système de tête HES (« Head-End System » en anglais) 140 auquel l'entité de gestion MDM 130 peut déléguer des traitements. L'entité de gestion MDM 130 comporte alors une interface 113' de communication avec un réseau de communication 102' lui permettant de communiquer avec le système de tête HES 140. De même, le système de tête HES 140 comporte une interface 113' de communication avec un réseau de communication 102' lui permettant de communiquer avec l'entité de gestion MDM 130. De plus, le système de tête HES 140 comporte une interface 113 de communication avec un réseau de communication 102 lui permettant de communiquer avec un ou plusieurs dispositifs concentrateurs de données DC 110. Le réseau de communication 102' est par exemple de type IP, tel que l'Internet.

L'entité de gestion MDM 130 est préférentiellement conforme à l'ensemble de standards IEC 62056, *i.e.* aux spécifications DLMS (« Device Language Message Spécification » en anglais) et COSEM (« Companion Specification for Energy Metering » en anglais).

L'entité de gestion MDM 130 comporte en outre une interface 114 de communication avec un réseau de communication 104 de type IP, tel que l'Internet, pour lui permettre notamment de communiquer avec des passerelles résidentielles RGW (« Résidentiel GateWay » en anglais) 150. De telles passerelles résidentielles RGW 150 sont typiquement fournies par des opérateurs fournisseurs d'accès à l'Internet et installées chez les particuliers ou dans des locaux d'entreprise. En d'autres termes, un utilisateur qui dispose d'un compteur électrique intelligent C 120 pour gérer l'alimentation électrique de son habitation ou de son local dispose aussi souvent d'une passerelle résidentielle RGW 150 pour accéder à l'Internet depuis cette habitation ou ce local.

Les passerelles résidentielles RGW 150 comportent aussi une interface 114 de communication avec le réseau de communication 104 de type IP pour notamment leur permettre de communiquer avec l'entité de gestion MDM 130. Chaque passerelle résidentielle RGW 150 comporte en outre une interface 112 de communication avec un réseau de communication 103 de type WLAN (« Wireless Local Area Network » en anglais) que ladite passerelle résidentielle RGW 150 crée et gère. Le réseau de communication 103 est préférentiellement de type Wi-Fi, tel que défini dans la famille de standard IEEE 802.11.

Les compteurs électriques intelligents C 120 diffèrent des compteurs électriques intelligents C' 121 en ce que les compteurs électriques intelligents C 120 comportent en outre une interface de communication 112 avec un réseau de communication de type WLAN. Les compteurs électriques intelligents C 120 sont ainsi aptes à communiquer avec l'entité de gestion MDM 130 en s'appuyant sur un dit réseau de communication 103 pour utiliser une dite passerelle résidentielle RGW 150 comme relais avec l'entité de gestion MDM 130. A noter que le système de communication de la Fig. 1A peut ne contenir que des compteurs électriques intelligents C 120, c'est-à-dire disposant de l'interface de communication 112.

Un tel agencement du système de communication offre alors deux alternatives pour permettre aux compteurs électriques intelligents C 120 de recevoir des données depuis l'entité de gestion MDM 130. Les réseaux de communication 103 et 104 étant plus stables et pouvant offrir un débit plus important que le réseau de communication par courants porteurs en ligne 101, les compteurs électriques intelligents C 120 privilégient leur interface 112 de communication pour recevoir des données volumineuses en provenance de l'entité de gestion MDM 130. On entend par « données volumineuses » une quantité de données supérieure à un premier seuil TH1 prédéfini (par exemple « 200 » kOctets) au-delà duquel la transmission de cette quantité de données par le réseau de communication par courants porteurs en ligne 101 a une probabilité supérieure à un second seuil TH2 déterminé dynamiquement par le MDM 130 de subir une reconfiguration du réseau de communication par courants porteurs en ligne 101. Par exemple, le transfert d'une mise à jour logicielle des compteurs électriques intelligents C 120 est typiquement considérée comme un transfert de données volumineuses.

Cependant, les communications par courants porteurs en ligne sont garanties alors que les communications via Wi-Fi ne le sont pas.

Dans un mode de réalisation, l'entité de gestion MDM 130 collecte régulièrement au niveau de chaque compteur électrique intelligent C 120, d'une part une table de routage (qui indique des routes de communication utilisées par ledit compteur), et d'autre part une table des voisins (qui indique d'autres éléments du réseau avec lequel ledit compteur a échangé des données). A partir de ces tables, l'entité de gestion MDM 130 détermine, pour un ensemble de compteurs électriques intelligents C 120 donnés (par exemple ceux dépendant d'un dispositif concentrateur de données DC 110 donné), une densité de probabilité que le réseau de communication par courants porteurs en ligne 101 reliant les compteurs électriques intelligents C 120 dudit ensemble à leur dispositif concentrateur de données DC 110 se reconfigure. Il mesure pour cela des périodes entre deux reconfigurations et en déduit une courbe de Gauss représentative de ladite densité de probabilité. Ainsi, lorsqu'une reconfiguration du réseau de communication par courants porteurs en ligne 101 se produit à un instant *T0,* l'entité de gestion MDM 130 lance une mesure de temps à partir de *T0.* Chaque instant *T* suivant l'instant *T0* est associé à une probabilité *P* d'échec d'une transmission de données via le réseau de communication par courants porteurs en ligne 101 reliant les compteurs électriques intelligents C 120 dudit ensemble à leur dispositif concentrateur de données DC 110. La probabilité d'échec *P* est une aire de la densité de probabilité entre *T0* et *T.*

On nomme *R* une probabilité de réussite associée à *P. R*=*1-P.*

Ainsi, lorsqu'un compteur électrique intelligent C 120 dudit ensemble doit télécharger des données en provenance de l'entité de gestion MDM 130, il reçoit de l'entité de gestion MDM 130 une probabilité de réussite *R* concernant ledit ensemble. Cette probabilité de réussite correspond au moment où le compteur électrique intelligent débutera le téléchargement, c'est-à-dire qu'elle représente la probabilité que le réseau de communication par courants porteurs en ligne 101 reliant le compteur électrique intelligent C 120 à son dispositif concentrateur de données 110 ne subisse pas une reconfiguration pendant le téléchargement dudit compteur à partir du moment où le compteur électrique intelligent C 120 débutera son téléchargement. Il sait de plus quelle est la quantité des données à télécharger *Q.*

Le compteur électrique intelligent C 120 dispose en interne d'une courbe de décision prédéfinie lui permettant de choisir s'il peut utiliser le réseau de communication par courants porteurs en ligne 101 pour le téléchargement des données ou pas. La courbe de décision prédéfinie a pour abscisse des valeurs représentatives de probabilités *R* de réussite d'un téléchargement effectué sur le réseau de communication par courants porteurs en ligne 101 liée à une reconfiguration du réseau, et pour ordonnée des valeurs représentatives de quantités de données à télécharger. Cette courbe coupe l'axe des abscisses à la valeur de probabilité « 1 » (*i.e.* correspondant à 100% de chance de télécharger intégralement des données de taille « 0 » octet par le réseau de communication par courants porteurs en ligne 101), et l'axe des ordonnées à une valeur *Y0.* Dans un mode de réalisation, *Y0* est fixée à 800 kOctets, c'est-à-dire qu'à partir de 800 kOctets, on considère que la probabilité de réussite d'un téléchargement via le réseau de communication par courants porteurs en ligne 101 est nulle. Dans un mode de réalisation, la valeur *Y0* est déterminée par l'entité de gestion MDM 130 et fournie à chaque compteur électrique intelligent C 120. Dans un mode de réalisation, la courbe prédéfinie est une droite d'équation *y* = *-Y*0(*r*) + *Y*0*,* ou r (=1*-p*) est une valeur de probabilité comprise entre zéro et l'unité.

Le compteur électrique intelligent C 120 prend la décision d'effectuer un téléchargement via le réseau de communication par courants porteurs en ligne 101 si, pour la probabilité de réussite *R* fournie par l'entité de gestion MDM 130, la quantité de données à télécharger *Q* est inférieure à *y_{R}* = *-Y*0(*R*) + *Y*0. Sinon, Le compteur électrique intelligent C 120 prend la décision d'effectuer un téléchargement via les réseaux de communication 103 et 104. On suppose ici que le compteur électrique intelligent C 120 prend la décision dès réception de la probabilité *R,* et commence le téléchargement immédiatement après la prise de décision, de sorte que la probabilité *R* fournie par l'entité de gestion MDM 130 est valide pour ledit téléchargement.

A noter que les communications entre les compteurs électriques intelligents C 120, C' 121 et l'entité de gestion MDM 130 s'effectuent préférentiellement de manière chiffrée, quel que soit le chemin de données utilisé, par exemple en établissant des réseaux privés virtuels VPN (« Virtual Private Network » en anglais).

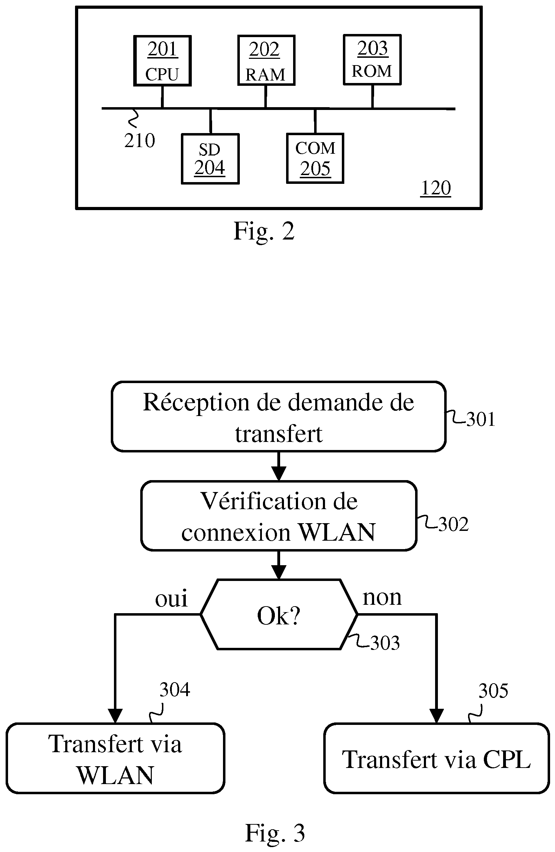

La **Fig.2** illustre schématiquement un exemple d'architecture matérielle de contrôle de compteur électrique intelligent C 120.

Le compteur électrique intelligent C 120 en question comprend alors, reliés par un bus de communication 210 : un processeur ou CPU (« Central Processing Unit » en anglais) 201 ; une mémoire vive RAM (« Random Access Memory » en anglais) 202 ; une mémoire morte ROM (« Read Only Memory » en anglais) 203 ; une unité de stockage 204, tel qu'un disque dur HDD (« Hard Disk Drive » en anglais), ou un lecteur de support de stockage, tel qu'un lecteur de cartes SD (« Secure Digital » en anglais) ; un ensemble d'interfaces COM 205 permettant au dispositif de communication de communiquer au sein du système de communication de la Fig. 1A.

Le processeur 201 est capable d'exécuter des instructions chargées dans la mémoire RAM 202 à partir de la mémoire ROM 203, d'une mémoire externe (non représentée), d'un support de stockage (tel qu'une carte SD), ou d'un réseau de communication. Lorsque le compteur électrique intelligent C 120 en question est mis sous tension, le processeur 201 est capable de lire de la mémoire RAM 202 des instructions et de les exécuter. Ces instructions forment un programme d'ordinateur causant une implémentation, par le processeur 201, de tout ou partie des algorithmes et étapes décrits ci-après.

Tout ou partie des algorithmes et étapes décrits ci-après peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

D'une manière générale, chaque compteur électrique intelligent C 120 comporte ainsi de la circuiterie électronique configurée pour implémenter tout ou partie des algorithmes et étapes décrits ci-après.

La **Fig. 3** illustre schématiquement un algorithme, exécuté par chaque compteur électrique intelligent C 120, pour recevoir des données depuis l'entité de gestion MDM 130.

Dans une étape 301, ledit compteur électrique intelligent C 120 reçoit, via l'interface 111 de communication avec le réseau de communication par courants porteurs en ligne 101, une demande de transfert en provenance de l'entité de gestion MDM 130. En d'autres termes, l'entité de gestion MDM 130 indique qu'un transfert de données, à l'attention dudit compteur électrique intelligent C 120, est en attente auprès de l'entité de gestion MDM 130. Préférentiellement, la demande de transfert indique quelle quantité de données sont à transférer depuis l'entité de gestion MDM 130. Par exemple, une telle demande de transfert est une mise à jour logicielle destinée audit compteur électrique intelligent C 120 ou une mise à jour de profil utilisateur associé à un utilisateur dudit compteur électrique intelligent C 120.

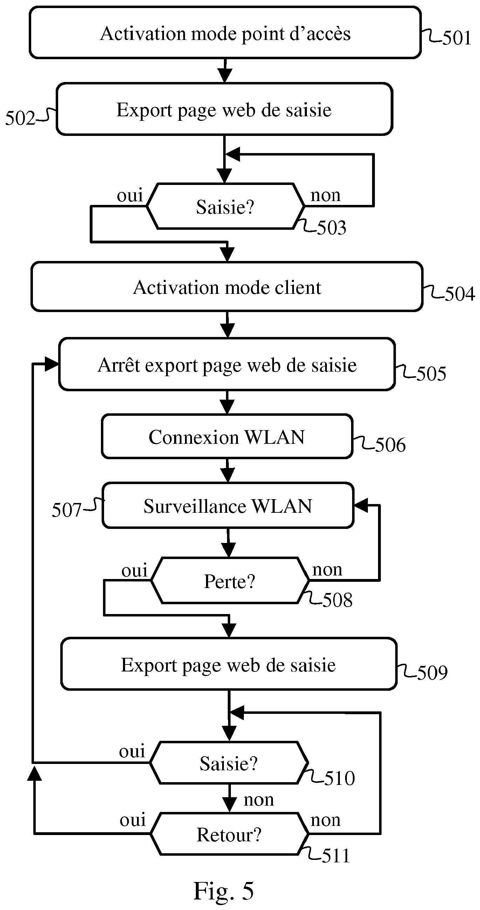

Dans une étape 302, ledit compteur électrique intelligent C 120 détermine si ledit compteur électrique intelligent C 120 dispose d'une connexion, via un dit réseau de communication 103, avec une passerelle résidentielle RGW 150 lui permettant de communiquer avec l'entité de gestion MDM 130 par son biais. Cet aspect est détaillé ci-après en relation avec la Fig. 5.

Dans une étape 303, ledit compteur électrique intelligent C 120 vérifie si ledit compteur électrique intelligent C 120 dispose ou pas de ladite connexion. Si tel est le cas, une étape 304 est effectuée ; sinon, une étape 305 est effectuée.

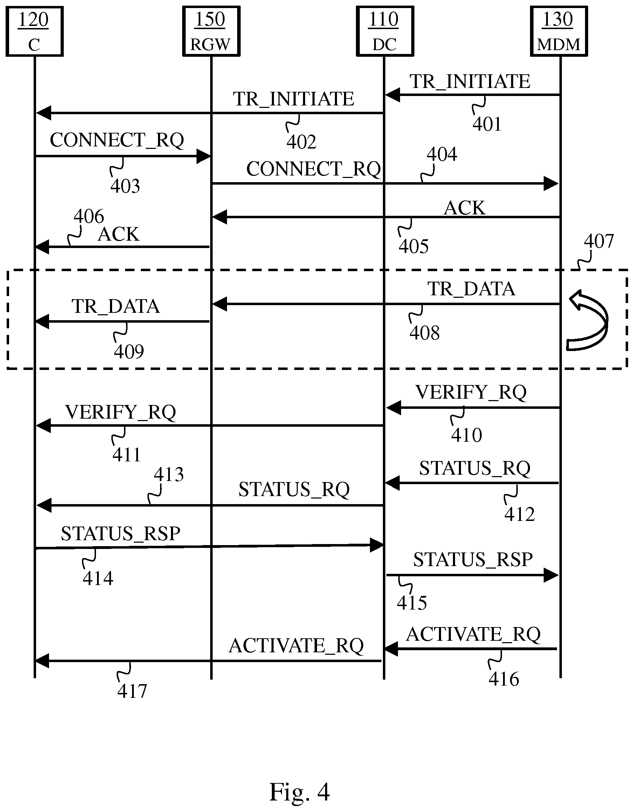

Dans l'étape 304, ledit compteur électrique intelligent C 120 organise le transfert via le réseau de communication 103 de type WLAN, c'est-à-dire en s'appuyant sur la passerelle résidentielle RGW 150 qui est le point d'accès AP dudit réseau de communication 103. Cet aspect est détaillé ci-après en relation avec la Fig. 4.

Dans l'étape 305, ledit compteur électrique intelligent C 120 organise le transfert via le réseau de communication par courants porteurs en ligne 101, comme cela s'effectue habituellement dans le cadre de systèmes de type AMM.

Dans un mode de réalisation particulier, pour décider quel biais utiliser pour effectuer le transfert de données depuis l'entité de gestion MDM 130, ledit compteur électrique intelligent C 120 vérifie en outre si les données à transférer depuis l'entité de gestion MDM 130 sont volumineuses ou pas. Ledit compteur électrique intelligent C 120 vérifie donc si la quantité de données à transférer depuis l'entité de gestion MDM 130 est ou pas supérieure au premier seuil TH1 prédéfini. Si tel est le cas, ledit compteur électrique intelligent C 120 organise le transfert via le réseau de communication 103 de type WLAN si ledit compteur électrique intelligent C 120 dispose de la connexion correspondante, et sinon ledit compteur électrique intelligent C 120 organise le transfert via le réseau de communication par courants porteurs en ligne 101. En variante, ledit compteur électrique intelligent C 120 sait par avance que tel ou tel type de transfert est supposé être organisé pour s'effectuer via le réseau de communication 103 de type WLAN si ledit compteur électrique intelligent C 120 dispose de la connexion correspondante. Dans ce cas, la demande de transfert indique de quel type est le transfert en question (mise à jour logicielle,...).

La **Fig. 4** illustre schématiquement un échange de messages dans le cadre d'un transfert de données dans le système de communication de la Fig. 1A, dans un mode de réalisation de la présente invention. Il est y considéré un compteur électrique intelligent C 120 qui dispose d'une connexion, via un dit réseau de communication 103, avec une passerelle résidentielle RGW 150 lui permettant de communiquer avec l'entité de gestion MDM 130 par son biais.

Dans une étape 401, l'entité de gestion MDM 130 transmet un message TR_INITIATE qui indique audit compteur électrique intelligent C 120 qu'un transfert de données, à l'attention dudit compteur électrique intelligent C 120, est en attente auprès de l'entité de gestion MDM 130. L'entité de gestion MDM 130 transmet le message TR INITIATE par le biais du concentrateur de données DC 110 auquel est rattaché ledit compteur électrique intelligent C 120. En effet, l'entité de gestion MDM 130 n'est pas informée du fait que ledit compteur électrique intelligent C 120 dispose ou pas d'une connexion effective via une dite passerelle résidentielle RGW 150. Dans le cas d'une mise à jour logicielle dans un cadre DLMS/COSEM, le message TR_INITIATE est un message dénommé « image_transfer_initiate ».

Dans une étape 402, ledit concentrateur de données DC 110 fait suivre ledit message TR INITIATE audit compteur électrique intelligent C 120 via le réseau de communication par courants porteurs en ligne 101.

Dans une étape 403, suite au message TR INITIATE et après avoir vérifié disposer effectivement d'une connexion avec une passerelle résidentielle RGW 150, ledit compteur électrique intelligent C 120 transmet un message CONNECT_RQ à destination de l'entité de gestion MDM 130 via le réseau de communication 103.

Dans une étape 404, ladite passerelle résidentielle RGW 150 route le message CONNECT_RQ à destination de l'entité de gestion MDM 130 via le réseau de communication 104. Le message CONNECT_RQ indique une demande de connexion via le réseau de communication 104 et donc via ladite passerelle résidentielle RGW 150. Préférentiellement, le message CONNECT_RQ est une demande d'établissement de connexion sous la forme d'un réseau privé virtuel VPN à transmissions chiffrées.

Dans une étape 405, l'entité de gestion MDM 130 transmet un message ACK qui acquitte et confirme la demande d'établissement de connexion du message CONNECT_RQ. L'entité de gestion MDM 130 transmet le message ACK à destination dudit compteur électrique intelligent C 120 via le réseau de communication 104 et donc via ladite passerelle résidentielle RGW 150.

Dans une étape 406, ladite passerelle résidentielle RGW 150 fait suivre le message ACK audit compteur électrique intelligent C 120 via le réseau de communication 103.

Dans une étape 407, le transfert de données concerné par le message TR_INITIATE s'effectue depuis l'entité de gestion MDM 130 vers ledit compteur électrique intelligent C 120. Ledit compteur électrique intelligent C 120 peut récupérer les données en question auprès de l'entité de gestion MDM 130 via ladite passerelle résidentielle RGW 150. En variante, l'entité de gestion MDM 130 peut pousser les données en question vers ledit compteur électrique intelligent C 120 via ladite passerelle résidentielle RGW 150, comme représenté sur la Fig. 4. Ainsi, dans une étape 408, l'entité de gestion MDM 130 transmet une partie des données en question dans un message TR_DATA, et dans une étape 409, ladite passerelle résidentielle RGW 150 fait suivre le message TR_DATA audit compteur électrique intelligent C 120 via le réseau de communication 103. Les étapes 408 et 409 sont répétées jusqu'à ce que l'intégralité des données en question soient transmises depuis l'entité de gestion MDM 130 jusqu'audit compteur électrique intelligent C 120.

Par exemple, un protocole de transfert de type FTP (« File Transfert Protocol » en anglais) peut être mis en œuvre pour exécuter l'étape 407.

A l'issue du transfert de données, l'entité de gestion MDM 130 et ledit compteur électrique intelligent C 120 effectuent des échanges de confirmation de transfert réussi, via le réseau de communication par courants porteurs en ligne 101, comme détaillé ci-après dans un mode de réalisation particulier.

Dans une étape 410, l'entité de gestion MDM 130 transmet un message VERIFY_RQ qui instruit ledit compteur électrique intelligent C 120 d'effectuer une vérification d'intégrité des données reçues. Les données (ou le message VERIFY_RQ) contiennent typiquement une somme de contrôle CRC (« Cyclic Redundancy Check » en anglais) ou un résultat de hachage pour ce faire. L'entité de gestion MDM 130 transmet le message VERIFY_RQ par le biais du concentrateur de données DC 110 auquel est rattaché ledit compteur électrique intelligent C 120. Dans le cas d'une mise à jour logicielle dans un cadre DLMS/COSEM, le message VERIFY_RQ est un message dénommé « image_verify ».

Dans une étape 411, ledit concentrateur de données DC 110 fait suivre ledit message VERIFY_RQ audit compteur électrique intelligent C 120 via le réseau de communication par courants porteurs en ligne 101. Sur réception du message VERIFY_RQ, ledit compteur électrique intelligent C 120 effectue une vérification d'intégrité des données reçues.

Dans une étape 412, l'entité de gestion MDM 130 transmet un message STATUS_RQ qui demande audit compteur électrique intelligent C 120 d'indiquer en réponse quel est le résultat de la vérification d'intégrité. Dans le cas d'une mise à jour logicielle dans un cadre DLMS/COSEM, le message STATUS_RQ est un message dénommé « GET(image_transfer_status) ».

Dans une étape 413, ledit concentrateur de données DC 110 fait suivre ledit message STATUS_RQ audit compteur électrique intelligent C 120 via le réseau de communication par courants porteurs en ligne 101.

Dans une étape 414, ledit compteur électrique intelligent C 120 transmet un message STATUS_RSP à destination de l'entité de gestion MDM 130 via le réseau de communication par courants porteurs en ligne 101. Le message STATUS_RSP inclut le résultat de la vérification d'intégrité. Dans le cas d'une mise à jour logicielle dans un cadre DLMS/COSEM, le message STATUS_RSP est un message dénommé « transfer_status ».

Dans une étape 415, ledit concentrateur de données DC 110 fait suivre ledit message STATUS_RSP à l'entité de gestion MDM 130. Dans le cas où le résultat de la vérification d'intégrité montre que des données ont été corrompues pendant le transfert, les étapes 408 et 409 sont répétées pour un nouveau transfert. Sinon, dans une étape 416, l'entité de gestion MDM 130 transmet un message ACTIVATE_RQ qui instruit ledit compteur électrique intelligent C 120 de prendre en compte (*i.e*. d'activer) les données qui lui ont été transférées et dont l'intégrité a été vérifiée avec succès. Par exemple, si les données concernent une mise à jour logicielle dudit compteur électrique intelligent C 120, le message ACTIVATE_RQ instruit ledit compteur électrique intelligent C 120 de commuter sur le logiciel mis à jour. Dans le cas d'une mise à jour logicielle dans un cadre DLMS/COSEM, le message ACTIVATE_RQ est un message dénommé « image_activate ».

Dans une étape 417, ledit concentrateur de données DC 110 fait suivre ledit message ACTIVATE_RQ audit compteur électrique intelligent C 120 via le réseau de communication par courants porteurs en ligne 101.

Ainsi, la majeure partie des échanges dans le cadre du transfert des données volumineuses est réalisée via les réseaux de communication 103 et 104, alors que les messages d'administration du système de type AMM sont transmis via le réseau de communication par courants porteurs en ligne 101, de sorte que ledit concentrateur de données DC 110 est informé de l'exécution du transfert, ainsi que potentiellement le système de tête HES 140, et surtout, cela permet de contrôler en particulier, grâce à l'emploi du réseau de communication par courants porteurs en ligne 101, le basculement vers le logiciel téléchargé en cas de téléchargement de mise à jour logicielle. En effet, le réseau de communication par courants porteurs en ligne 101 est typiquement un réseau de communication privé alors que le réseau de communication 104 est typiquement un réseau de communication public, et le contrôle du basculement vers le logiciel téléchargé est plus sûr en effectuant les transmissions des messages d'administration du système de type AMM via le réseau de communication par courants porteurs en ligne 101.

La **Fig. 5** illustre schématiquement un algorithme, exécuté par au moins un compteur électrique intelligent C 120, pour configurer une interface de communication dudit compteur électrique intelligent C120.

Dans une étape 501, ledit compteur électrique intelligent C 120 active un mode de fonctionnement en point d'accès AP sur son interface 112 de communication adaptée aux réseaux WLAN créés et gérés par les passerelles résidentielles RGW 150. Ledit compteur électrique intelligent C 120 permet ainsi que des terminaux sans-fil s'y connectent.

Dans une étape 502, ledit compteur électrique intelligent C 120 exporte, grâce à un serveur web, une page web de saisie. Un installeur ou un utilisateur dudit compteur électrique intelligent C 120 est alors capable d'effectuer une saisie de nom de réseau WLAN (*e*.*g*. SSID (« Service Set IDentifier » en anglais) et de mot de passe applicable, grâce à un terminal sans-fil de configuration, via cette page web de saisie.

Dans une étape 503, ledit compteur électrique intelligent C 120 vérifie si une saisie de nom de réseau WLAN et de mot de passe applicable est effectuée ou pas. Si tel est le cas, une étape 504 est effectuée ; sinon, l'étape 503 est répétée.

Dans l'étape 504, ledit compteur électrique intelligent C 120 active un mode de fonctionnement en client, et dans une étape 505, arrête d'exporter la page de web de saisie.

Dans l'étape 506, ledit compteur électrique intelligent C 120 effectue une connexion au réseau de communication de type WLAN dont le nom et le mot de passe ont été saisis. Le nom et le mot de passe saisis sont supposés être le nom et le mot de passe associés au réseau de communication 103 créé et géré par la passerelle résidentielle RGW 150 que ledit compteur électrique intelligent C 120 peut utiliser pour contacter l'entité de gestion MDM 150. A noter que si la saisie s'avère avoir été incorrecte, l'étape 501 est répétée.

Dans une étape 507, ledit compteur électrique intelligent C 120 effectue une surveillance dudit réseau de communication de type WLAN, pour s'assurer que ledit réseau de communication de type WLAN reste opérationnel.

Dans une étape 508, ledit compteur électrique intelligent C 120 vérifie s'il y a une perte de connexion avec ladite passerelle résidentielle RGW 150 ou pas, c'est-à-dire que ledit compteur électrique intelligent C 120 vérifie si ledit réseau de communication de type WLAN est toujours présent ou pas. S'il y a eu perte de connexion, une étape 509 est effectuée ; sinon, l'étape 507 est répétée.

Dans l'étape 509, ledit compteur électrique intelligent C 120 exporte à nouveau la page web de saisie.

Dans une étape 510, ledit compteur électrique intelligent C 120 vérifie si une saisie de nom de réseau WLAN et de mot de passe applicable est effectuée ou pas. Si tel est le cas, l'étape 505 est répétée avec ce nom de réseau WLAN et ce mot de passe. C'est le cas par exemple lorsque l'utilisateur remplace sa passerelle résidentielle RGW 150 par une autre (*e.g.* lors d'un changement d'opérateur fournisseur d'accès à l'Internet) ou que l'utilisateur change le nom et/ou le mot de passe du réseau de communication WLAN créé et généré par sa passerelle résidentielle RGW 150. Sinon, une étape 511 est effectuée.

Dans l'étape 511, ledit compteur électrique intelligent C 120 vérifie si un retour du réseau de communication de type WLAN est observé. C'est le cas par exemple lorsque l'utilisateur rallume sa passerelle résidentielle RGW 150 après l'avoir éteinte. Si tel est le cas, l'étape 505 est répétée avec le nom de réseau WLAN et le mot de passe qui avaient été précédemment saisis ; sinon, l'étape 510 est répétée.

A noter que le mode de fonctionnement en point d'accès AP et le mode de fonctionnement en client dudit compteur électrique intelligent C 120 peuvent être actifs simultanément, comme représenté dans la Fig. 5 (à partir de l'étape 504). En variante, le mode de fonctionnement en point d'accès AP et le mode de fonctionnement en client dudit compteur électrique intelligent C 120 peuvent être exclusifs. Dans ce cas, ledit compteur électrique intelligent C 120 stoppe le mode de fonctionnement en point d'accès AP lorsqu'il active le mode de fonctionnement en client, et vice versa. Plus particulièrement, ledit compteur électrique intelligent C 120 active le mode de fonctionnement en point d'accès AP lorsque la page web de saisie doit être exportée pour obtenir le nom et le mot de passe du réseau de communication 103 créé et généré par ladite passerelle résidentielle RGW 150. A noter aussi que ledit compteur électrique intelligent C 120 peut n'exporter la page web de saisie que lorsque ledit compteur électrique intelligent C 120 ne dispose pas de nom et de mot de passe de réseau de communication 103 auquel ledit compteur électrique intelligent C 120 peut effectivement se connecter (réseau présent, mot de passe correct). En variante, ledit compteur électrique intelligent C 120 peut exporter la page web de saisie en permanence. Dans encore une autre variante, ledit compteur électrique intelligent C 120 peut n'exporter la page web de saisie que lorsque l'utilisateur ou l'installateur appuie sur un bouton dudit compteur électrique intelligent C 120, et arrêter d'exporter la page web de saisie lorsque l'utilisateur ou l'installateur réappuie sur ledit bouton ou relâche ledit bouton.

Dans un mode de réalisation particulier, l'accès à la page web de saisie se fait en saisissant dans une page web préalable un mot de passe d'administration, connu dudit compteur électrique intelligent C 120.

La procédure décrite ci-dessus en relation avec la Fig. 5 est particulièrement utile lorsque les opérateurs régissant ledit compteur électrique intelligent C 120 et ladite passerelle résidentielle RGW 150 sont distincts. Lorsqu'un même opérateur régit ledit compteur électrique intelligent C 120 et ladite passerelle résidentielle RGW 150, le nom et le mot de passe attendus par ladite passerelle résidentielle RGW 150 peuvent être préconfigurés dans le compteur électrique intelligent C 120, par exemple en usine.

## Revendications

1. Procédé pour transmettre des données depuis une entité de gestion (130) dans un système de communication comportant en outre au moins un dispositif concentrateur de données (110) auquel sont rattachés des compteurs électriques intelligents (120, 121) via un premier réseau de communication par courants porteurs en ligne (101), chaque dispositif concentrateur de données (110) étant connecté à l'entité de gestion (130) via un second réseau de communication (102),
le procédé étant tel que, pour transmettre des données depuis l'entité de gestion (130) vers un dit compteur électrique intelligent (120), ledit compteur électrique intelligent (120) reçoit, en provenance de l'entité de gestion (130), via le premier réseau de communication par courants porteurs en ligne (101), un message indiquant qu'un transfert de données est en attente auprès de l'entité de gestion ;
ledit compteur électrique intelligent (120) comportant une interface de communication sans-fil (112) adaptée pour communiquer via un troisième réseau de communication local sans-fil (103) avec une passerelle résidentielle (150) connectée à l'entité de gestion via un quatrième réseau de communication (104), le procédé étant tel que ledit compteur électrique intelligent (120) obtient lesdites données auprès de l'entité de gestion (130) via le troisième réseau de communication local sans-fil (103).

2. Procédé selon la revendication 1, **caractérisé en ce que**, sur réception du message indiquant que le transfert de données est en attente auprès de l'entité de gestion (130), ledit compteur électrique intelligent (120) effectue les étapes suivantes :
- déterminer (302) si ledit compteur électrique intelligent (120) dispose d'une connexion, via ledit troisième réseau de communication local sans-fil (103), avec ladite passerelle résidentielle (150) lui permettant de communiquer avec l'entité de gestion (130) par son biais ;
- obtenir lesdites données auprès de l'entité de gestion (130) via le troisième réseau de communication local sans-fil (103) lorsque ledit compteur électrique intelligent (120) dispose d'une connexion, via ledit troisième réseau de communication local sans-fil (103), avec ladite passerelle résidentielle (150) ; et
- obtenir lesdites données auprès de l'entité de gestion (130) via le premier réseau de communication par courants porteurs en ligne (101) lorsque ledit compteur électrique intelligent (120) ne dispose pas d'une connexion, via ledit troisième réseau de communication local sans-fil (103), avec ladite passerelle résidentielle (150).

3. Procédé selon la revendication 2, **caractérisé en ce que** ledit compteur électrique intelligent (120) vérifie en outre si la quantité de données à transférer depuis l'entité de gestion (130) est ou pas supérieure à un premier seuil prédéfini au-delà duquel la transmission de cette quantité de données par le réseau de communication par courants porteurs en ligne (101) a une probabilité supérieure à un second seuil prédéfini de subir une reconfiguration du réseau de communication par courants porteurs en ligne (101), et
et **en ce que** ledit compteur électrique intelligent (120) obtient lesdites données auprès de l'entité de gestion (130) via le troisième réseau de communication local sans-fil (103) lorsque ledit compteur électrique intelligent (120) dispose d'une connexion, via ledit troisième réseau de communication local sans-fil (103), avec ladite passerelle résidentielle (150) et en outre que la quantité de données à transférer est supérieure audit premier seuil prédéfini.

4. Procédé selon la revendication 2, **caractérisé en ce que** ledit compteur électrique intelligent (120) vérifie en outre si la quantité de données à transférer depuis l'entité de gestion (130) est ou pas inférieure à une valeur, dite valeur limite, obtenue à partir d'une courbe prédéfinie et d'une probabilité de réussite fournie par l'entité de gestion (130) représentative d'une probabilité que le réseau de communication par courants porteurs en ligne (101) ne subisse pas une reconfiguration pendant le téléchargement à partir du moment où le compteur électrique intelligent (120) débutera ledit téléchargement, ladite courbe prédéfinie reliant des quantités de données à télécharger à des valeurs représentatives de probabilités de réussite d'un téléchargement effectué via le réseau de communication par courants porteurs en ligne (101), ledit compteur électrique intelligent (120) obtenant lesdites données auprès de l'entité de gestion (130) via le réseau de communication par courant porteur en ligne (101) lorsque la quantité de données à transférer est inférieure à la valeur limite.

5. Procédé selon l'une quelconque des revendications 2, 3 ou 4, **caractérisé en ce que** ledit compteur électrique intelligent (120) exporte, via son interface de communication sans-fil (112), une page web de saisie pour permettre de saisir un nom de réseau et un mot de passe, et **en ce que** ledit compteur électrique intelligent (120) se connecte à ladite passerelle résidentielle (150) grâce au nom de réseau et au mot de passe saisis via ladite page web de saisie.

6. Procédé selon la revendication 5, **caractérisé en ce que** ledit compteur électrique intelligent (120) exporte la page web de saisie uniquement lorsque ledit compteur électrique intelligent (120) ne dispose pas de nom de réseau et de mot de passe permettant d'utiliser son interface de communication sans-fil (112) pour communiquer avec l'entité de gestion (130).

7. Procédé selon l'une quelconque des revendications 1 à 6, **caractérisé en ce que**, après avoir obtenu lesdites données auprès de l'entité de gestion (130) via le troisième réseau de communication local sans-fil (103), ledit compteur électrique intelligent (120) effectue avec l'entité de gestion (130) des échanges de confirmation de transfert réussi, lesdits échanges s'effectuant via le premier réseau de communication par courants porteurs en ligne (101).

8. Procédé selon l'une quelconque des revendications 1 à 6, **caractérisé en ce que** l'interface de communication sans-fil (112) est de type Wi-Fi.

9. Produit programme d'ordinateur, **caractérisé en ce qu'**il comporte des instructions entraînant l'exécution du procédé selon l'une quelconque des revendications 1 à 8, lorsque lesdites instructions sont exécutées par un processeur (201) d'un compteur électrique intelligent (120).

10. Support de stockage, **caractérisé en ce qu'**il stocke un programme d'ordinateur comportant des instructions entraînant l'exécution du procédé selon l'une quelconque des revendications 1 à 8, lorsque lesdites instructions sont lues et exécutées par un processeur (201) d'un compteur électrique intelligent (120).

11. Compteur électrique intelligent (210) configuré pour recevoir des données depuis une entité de gestion (130), le compteur électrique étant configuré pour être utilisé dans un système de communication comportant en outre au moins un dispositif concentrateur de données (110) auquel est rattachable au moins ledit compteur électrique intelligent (120) via un premier réseau de communication par courants porteurs en ligne (101), chaque dispositif concentrateur de données (110) étant connecté à l'entité de gestion (130) via un second réseau de communication (102),
le compteur électrique intelligent (120) comportant, pour transmettre des données depuis l'entité de gestion (130) vers un dit compteur électrique intelligent (120), des moyens pour recevoir, en provenance de l'entité de gestion (130), via le premier réseau de communication par courants porteurs en ligne (101), un message indiquant qu'un transfert de données est en attente auprès de l'entité de gestion (130) ;
ledit compteur électrique intelligent (120) comportant une interface de communication sans-fil (112) adaptée pour communiquer via un troisième réseau de communication local sans-fil (103) avec une passerelle résidentielle (150) connectée à l'entité de gestion via un quatrième réseau de communication (104), et des moyens pour obtenir lesdites données auprès de l'entité de gestion (130) via le troisième réseau de communication local sans-fil (103).

## Patentansprüche

1. Verfahren zur Übertragung von Daten von einer Managemententität (130) in einem Kommunikationssystem, das außerdem wenigstens eine Datenkonzentratorvorrichtung (110) umfasst, an die intelligente Elektrizitätszähler (120, 121) über ein erstes Powerline-Kommunikationsnetz (101) angeschlossen sind, wobei jede Datenkonzentratorvorrichtung (110) mit der Managemententität (130) über ein zweites Kommunikationsnetz (102) verbunden ist,
wobei in dem Verfahren zum Übertragen von Daten von der Managemententität (130) zu einem intelligenten Elektrizitätszähler (120) der intelligente Elektrizitätszähler (120) von der Managemententität (130) über das erste Powerline-Kommunikationsnetz (101) eine Nachricht empfängt, die angibt, dass auf Seiten der Managemententität eine Datenübertragung ansteht;
wobei der intelligente Elektrizitätszähler (120) eine drahtlose Kommunikationsschnittstelle (112) enthält, die dafür ausgelegt ist, über ein drittes drahtloses lokales Kommunikationsnetz (103) mit einem residenten Gateway (150), das mit der Managemententität über ein viertes Kommunikationsnetz (104) verbunden ist, zu kommunizieren,
wobei in dem Verfahren der intelligente Elektrizitätszähler (120) Daten, die auf Seiten der Managemententität (130) vorhanden sind, über das dritte drahtlose lokale Kommunikationsnetz (103) erhält.

2. Verfahren nach Anspruch 1, **dadurch gekennzeichnet, dass** der intelligente Elektrizitätszähler (120) bei Empfang der Nachricht, die angibt, dass die Übertragung von Daten, die auf Seiten der Managemententität (130) vorhanden sind, ansteht, die folgenden Schritte ausführt:
- Bestimmen (302), ob der intelligente Elektrizitätszähler (120) eine Verbindung über das dritte drahtlose lokale Kommunikationsnetz (103) mit dem residenten Gateway (150) herstellt, was ihm erlaubt, darüber mit der Managemententität (130) zu kommunizieren;
- Erhalten der Daten, die auf Seiten der Managemententität (130) vorhanden sind, über das dritte drahtlose lokale Kommunikationsnetz (103), wenn der intelligente Elektrizitätszähler (120) eine Verbindung über das dritte drahtlose lokale Kommunikationsnetz (103) mit dem residenten Gateway (150) herstellt; und
- Erhalten der Daten, die auf Seiten der Managemententität (130) vorhanden sind, über das erste Powerline-Kommunikationsnetz (101), wenn der intelligente Elektrizitätszähler (120) keine Verbindung über das dritte drahtlose lokale Kommunikationsnetz (103) mit dem residenten Gateway (150) herstellt.

3. Verfahren nach Anspruch 2, **dadurch gekennzeichnet, dass** der intelligente Elektrizitätszähler (120) außerdem verifiziert, ob die von der Managemententität (130) zu übertragende Datenmenge größer als ein erster im Voraus definierter Schwellenwert ist oder nicht, oberhalb dessen die Übertragung dieser Datenmenge durch das Powerline-Kommunikationsnetz (101) eine Wahrscheinlichkeit hat, die höher als ein zweiter im Voraus definierter Schwellenwert ist, bei dem eine Neukonfiguration des Powerline-Kommunikationsnetzes (101) erfolgt, und
dass der intelligente Elektrizitätszähler (120) die Daten, die auf Seiten der Managemententität (130) vorhanden sind, über das dritte drahtlose lokale Kommunikationsnetz (103) erhält, wenn der intelligente Elektrizitätszähler (120) eine Verbindung über das dritte drahtlose lokale Kommunikationsnetz (103) mit dem residenten Gateway (150) herstellt und wenn außerdem die zu übertragende Datenmenge größer als der im Voraus definierte erste Schwellenwert ist.

4. Verfahren nach Anspruch 2, **dadurch gekennzeichnet, dass** der intelligente Elektrizitätszähler (120) außerdem verifiziert, ob die von der Managemententität (130) zu übertragende Datenmenge kleiner als ein sogenannter Grenzwert ist oder nicht, der anhand einer im Voraus definierten Kurve und einer Erfolgswahrscheinlichkeit ist, die von der Managemententität (130) geliefert wird und eine Wahrscheinlichkeit dafür darstellt, dass das Powerline-Kommunikationsnetz (101) keine Neukonfiguration während des Fernladens ab dem Zeitpunkt, zu dem der intelligente Elektrizitätszähler (120) mit dem Fernladen beginnt, erfährt, wobei die im Voraus definierte Kurve Mengen fernzuladender Daten mit Werten verknüpft, die Erfolgswahrscheinlichkeiten eines Fernladens darstellen, das über das Powerline-Kommunikationsnetz (101) ausgeführt wird, wobei der intelligente Elektrizitätszähler (120) die Daten, die auf Seiten der Managemententität (130) vorhanden sind, über das Powerline-Kommunikationsnetz (101) erhält, wenn die zu übertragende Datenmenge kleiner als der Grenzwert ist.

5. Verfahren nach einem der Ansprüche 2, 3 oder 4, **dadurch gekennzeichnet, dass** der intelligente Elektrizitätszähler (120) über seine drahtlose Kommunikationsschnittstelle (112) eine Erfassungs-Web-Seite, die ermöglicht, einen Netznamen und ein Passwort zu erfassen, exportiert und dass sich der intelligente Elektrizitätszähler (120) mit dem residenten Gateway (150) kraft des Netznamens und des Passworts, die über die Erfassungs-Web-Seite erfasst worden sind, verbindet.

6. Verfahren nach Anspruch 5, **dadurch gekennzeichnet, dass** der intelligente Elektrizitätszähler (120) die Erfassungs-Web-Seite ausschließlich dann exportiert, wenn der intelligente Elektrizitätszähler (120) den Netznamen und das Passwort nicht angibt, was ermöglicht, seine drahtlose Kommunikationsschnittstelle (112) für die Kommunikation mit der Managemententität (130) zu verwenden.

7. Verfahren nach einem der Ansprüche 1 bis 6, **dadurch gekennzeichnet, dass** der intelligente Elektrizitätszähler (120), nachdem er die Daten, die auf Seiten der Managemententität (130) vorhanden sind, über das dritte drahtlose lokale Kommunikationsnetz (103) erhalten hat, mit der Managemententität (130) einen Austausch einer Bestätigung einer erfolgreichen Übertragung ausführt, wobei der Austausch über das erste Powerline-Kommunikationsnetz (101) erfolgt.

8. Verfahren nach einem der Ansprüche 1 bis 6, **dadurch gekennzeichnet, dass** die drahtlose Kommunikationsschnittstelle (112) vom WiFi-Typ ist.

9. Computerprogrammprodukt, **dadurch gekennzeichnet, dass** es Befehle enthält, die die Ausführung des Verfahrens nach einem der Ansprüche 1 bis 8 zur Folge haben, wenn diese Befehle durch einen Prozessor (201) eines intelligenten Elektrizitätszählers (120) ausgeführt werden.

10. Speicherträger, **dadurch gekennzeichnet, dass** er ein Computerprogramm speichert, das Befehle enthält, die die Ausführung des Verfahrens nach einem der Ansprüche 1 bis 8 zur Folge haben, wenn die Befehle von einem Prozessor (201) eines intelligenten Elektrizitätszählers (120) gelesen und ausgeführt werden.

11. Intelligenter Elektrizitätszähler (210), der konfiguriert ist, Daten von einer Managemententität (130) zu empfangen, wobei der Elektrizitätszähler konfiguriert ist, in einem Kommunikationssystem verwendet zu werden, das außerdem wenigstens eine Datenkonzentratorvorrichtung (110) enthält, an die wenigstens der intelligente Elektrizitätszähler (120) über ein erstes Powerline-Kommunikationsnetz (101) angeschlossen werden kann, wobei jede Datenkonzentratorvorrichtung (110) mit der Managemententität (130) über ein zweites Kommunikationsnetz (102) verbunden ist,
wobei der intelligente Elektrizitätszähler (120) für die Übertragung von Daten von der Managemententität (130) zu einem intelligenten Elektrizitätszähler (120) Mittel enthält, um von der Managemententität (130) über das erste Powerline-Kommunikationsnetz (101) eine Nachricht zu empfangen, die angibt, dass eine Datenübertragung auf Seiten der Managemententität (130) ansteht;
wobei der intelligente Elektrizitätszähler (120) eine drahtlose Kommunikationsschnittstelle (112) enthält, die dafür ausgelegt ist, über ein drittes drahtloses lokales Kommunikationsnetz mit einem residenten Gateway (150) zu kommunizieren, das mit der Managemententität über ein viertes Kommunikationsnetz (104) verbunden ist, und Mittel enthält, um die Daten, die auf Seiten der Managemententität (130) vorhanden sind, über das dritte drahtlose lokale Kommunikationsnetz (103) zu erhalten.

## Claims

1. Method for transmitting data from a management entity (130) in a communication system further comprising at least one data concentrator device (110) to which smart electricity meters (120, 121) are attached via a first powerline communication network (101), each data concentrator device (110) being connected to the management entity (130) via a second communication network (102),
the method being such that, in order to transmit data from the management entity (130) to a said smart electricity meter (120), said smart electricity meter (120) receives, coming from the management entity (130), via the first powerline communication network (101), a message indicating that a data transfer is pending with the management entity;
said smart electricity meter (120) comprising a wireless communication interface (112) adapted to communicate via a third wireless local communication network (103) with a residential gateway (150) connected to the management entity via a fourth communication network (104), the method being such that said smart electricity meter (120) obtains said data from the management entity (130) via the third wireless local communication network (103).

2. Method according to claim 1, **characterized in that**, on reception of the message indicating that the data transfer is pending with the management entity (130), said smart electricity meter (120) performs the following steps:
determining (302) whether said smart electricity meter (120) has a connection, via said third wireless local communication network (103), with said residential gateway (150) enabling it to communicate with the management entity (130) by means thereof;
obtaining said data from the management entity (130) via the third wireless local communication network (103) when said smart electricity meter (120) has a connection, via said third wireless local communication network (103), with said residential gateway (150); and
obtaining said data from the management entity (130) via the first powerline communication network (101) when said smart electricity meter (120) does not have a connection, via said third wireless local communication network (103), with said residential gateway (150).

3. Method according to claim 2, **characterized in that** said smart electricity meter (120) also checks whether or not the quantity of data to be transferred from the management entity (130) is higher than a first predefined threshold beyond which the transmission of this quantity of data by the powerline communication network (101) has a probability higher than a second predefined threshold of undergoing a reconfiguration of the powerline communication network (101),
and **in that** said smart electricity meter (120) obtains said data from the management entity (130) via the third wireless local communication network (103) when said smart electricity meter (120) has a connection, via said wireless local communication network (103), with said residential gateway (150) and furthermore when the quantity of data to be transferred is higher than said first predefined threshold.

4. Method according to claim 2, **characterized in that** said smart electricity meter (120) also checks whether or not the quantity of data to be transferred from the management entity (130) is below a value, referred to as the limit value, obtained from a predefined curve connecting quantities of data to be downloaded to values representing probabilities of success of a downloading performed via the powerline communication network (101) and representing a probability of success supplied by the management entity (130) representing a probability that the powerline communication network (101) does not undergo a reconfiguration during downloading as from the moment when the smart electricity meter (120) will begin said downloading, said smart electricity meter (120) obtaining said data from the management entity (130) via the powerline communication network (101) when the quantity of data to be transferred is below the limit value.

5. Method according to any one of claims 2, 3 or 4, **characterized in that** said smart electricity meter (120) exports, via the wireless communication interface (112) thereof, an entry web page for making it possible to enter a network name and a password, and said smart electricity meter (120) connects to said residential gateway (150) by means of the network name and the password entered via said entry web page.

6. Method according to claim 5, **characterized in that** said smart electricity meter (120) exports the entry web page only when said smart electricity meter (120) does not have a network name and a password making it possible to use its wireless communication interface (112) to communicate with the management entity (130).

7. Method according to any one of claims 1 to 6, **characterized in that**, after having obtained said data from the management entity (130) via the third wireless local communication network (103), said smart electricity meter (120) makes, with the management entity (130), exchanges confirming successful transfer, said exchanges taking place via the first powerline communication network (101).

8. Method according to any one of claims 1 to 6, **characterized in that** the wireless communication interface (112) is of the Wi-Fi type.

9. Computer program product, **characterized in that** it comprises instructions causing the execution of the method according to any one of claims 1 to 8, when said instructions are executed by a processor (201) of a smart electricity meter (120).

10. Storage medium, **characterized in that** it stores a computer program comprising instructions causing the execution of the method according to any one of claims 1 to 8, when said instructions are read and executed by a processor (201) of a smart electricity meter (120).

11. Smart electricity meter (120) configured to receive data from a management entity (130), the smart electricity meter being configured for being used in a communication system further comprising at least one data concentrator device (110) to which at least said smart electricity meter (120) is attachable via a first powerline communication network (101), each data concentrator device (110) being connected to the management entity (130) via a second communication network (102),
the smart electricity meter (120) comprising, to transmit data from the management entity (130) to said smart electricity meter (120), means for receiving, coming from the management entity (130), via the first powerline communication network (101), a message indicating that a data transfer is pending with the management entity (130),
said smart electricity meter (120) comprising a wireless communication interface (112) adapted to communicate, via a third wireless local communication network (103), with a residential gateway (150) connected to the management entity via a fourth communication network (104), and means for obtaining said data from the management entity (130) via the third wireless local communication network (103).
